# EUROPEAN PATENT SPECIFICATION

(11) **EP 0 633 295 B1**
(45) Date of publication and mention of the grant of the patent: **02.01.2002**
(21) Application number: 94905218.7
(22) Date of filing: 27.01.1994
(51) Int. Cl.: C08L 101/00, C08K 7/04

(54) **RESIN COMPOSITION FOR ELECTRONIC PARTS**
HARZZUSAMMENSETZUNG FUR ELEKTRONISCHE TEILE
COMPOSITION DE RESINE DESTINEE A DES COMPOSANTS ELECTRONIQUES

(30) Priority: 28.01.1993 JP 1279293; 23.07.1993 JP 20284793
(43) Date of publication of application: 11.01.1995
(73) Proprietor: OTSUKA KAGAKU KABUSHIKI KAISHA, Osaka-shi, Osaka 540 (JP)
(72) Inventor: TASAKA, Takio, 332-9, Aza Hachikitakaitaku, Itano-gun, Tokushima 771-02 (JP); MONDE, Hiroyuki, Mezondofurora 505, Itano-gun, Tokushima 771-02 (JP)
(74) Representative: Barz, Peter, Dr.
(86) International application number: JP9400113
(87) International publication number: WO9417140

(56) References cited:
- JP-A- 1 210 452
- JP-A- 2 055 761
- JP-A- 2 166 134

## Description

This invention relates to a method for reducing the dielectric loss tangent of thermoplastic or thermosetting resins which is highly demanded in electric and electronic circuit board substrates.

As the circuit board substrate material, the so-called glass-epoxy board manufactured by impregnating a glass mat with an epoxy resin, i.e. a thermosetting resin, and causing the resin to cure is generally employed. However, this substrate finds application only in planar printed circuit boards and, moreover, having a large dielectric constant of 4.5-5.5 and a large dielectric loss tangent of 0.020-0.035, is not fully satisfactory for the transmission of information because of the following circumstances.

Thus, the propagation delay time Td (ns/m) of an electric signal can be expressed by the equation Td=3.33√∈eff (∈eff: effective dielectric constant). It is seen from this equation that the smaller the dielectric constant, the shorter is the propagation delay time and the higher is the propagation speed, thus enabling a high-speed operation. On the other hand, the dielectric loss α_{D} (dB/m) in a strip line is subject to the relation α_{D}=27.3 x (f/c) x √∈ x tanδ (f= frequency, c=velocity of light, ∈= dielectric constant, tanδ=dielectric loss tangent). Thus, in order to decrease the dielectric loss, a substrate board with small dielectric constant and dielectric loss tangent values must be employed.

Recently, an injection-molded one-piece three-dimensional circuit board comprising a substrate board, a chassis and other structural components as a package has been manufactured by employing a thermoplastic resin as the resin matrix and either glass fiber, milled glass fiber or potassium titanate whiskers as the fiber reinforcement (JP-A-3035585) or a granular inorganic filler (talc, calcium pyrophosphate, etc.) without addition of reinforcing fibers. However, for a further sophistication of data communication or an enhancement of high-speed operability of data processing equipment, still further decreases in dielectric constant and dielectric loss tangent are needed.

Reinforcing fibers are added for enhancing the mechanical strength, improving the resistance to heat deformation during a soldering operation and reducing the coefficient of linear expansion (improving dimensional accuracy) of the matrix resin. However, with glass fiber or milled glass fiber, the dielectric constant of the substrate can be held comparatively low but the disadvantage occurs that because the dielectric loss is increased, the signal transmission rate required of a circuit board is decreased. In the data processing equipment of late, an ever higher transmission signal frequency is being sought after and as will be clear from the computation formula for dielectric loss, the above-mentioned disadvantage is assuming a more and more significant meaning.

Furthermore, glass fiber and milled glass fibers are fairly coarse, namely 5-15 µm in diameter and not less than 100 µm in length, so that such problems are inevitable as poor surface smoothness of the board, incidence of uncovered areas in the formation of delicate circuits in the plating or other process, and injury of the tip of a wire bonder in the connecting of gold conductors.

On the other hand, potassium titanate whiskers are a fine reinforcing material with a fiber diameter of 0.05-2 µm and a fiber length of 2-50 µm and when they are used in an electronic device resin composition, the whiskers contribute to increased mechanical strength, improved resistance to thermal deformation and lower linear expansion coefficient but have the drawback that their high dielectric constant detract from the speed of data transmission and the increased dielectric loss tangent resulting from its addition lowers the data transmission rate.

The inventors of this invention endeavoring to resolve the above problems discovered that by using a thermoplastic or thermosetting resin as the matrix resin and formulating it with a fiber component selected from whiskers of the composition represented by the general formula aAₓO_{y}•bB₂O₃ (wherein a and b each represents a whole number of 1-9, A represents a bivalent or trivalent metal, x and y each represents a whole number of 1-3) and either wollastonite or xonotlite, which is a fibrous substance composed predominantly of CaO·SiO₂, as the reinforcing fiber in certain proportions, the dielectric constant of the matrix resin can be held low (2.0-4.5) and yet the dielectric loss tangent can be rather decreased as compared with the matrix resin as such. Thus, it was confirmed that the dielectric constant required for said sophistication of data transmission can be held not higher than 3.5 and the dielectric loss tangent (tanδ) be held not over 0.001.

This invention is therefore concerned with a method for reducing the dielectric loss tangent of a thermoplastic resin or a thermosetting resin, comprising incorporating into the resin at least one of the fibers selected from wollastonite, xonotlite and whiskers in a proportion of 5 to 60% by weight, based on the combined weight of the resin and the fibers, said whiskers being represented by the formula aAₓO_{y}·bB₂O₃ (wherein a and b independently represent a whole number of 1 to 9; A represents a divalent or trivalent metal; and x and y independently represent a whole number of 1 to 3) and wollastonite and xonotlite being fibrous substances composed predominantly of CaO·SiO₂.

The thermoplastic resin that can be used in the practice of this invention includes poly(phenylene ether) resins having the following unit structure: 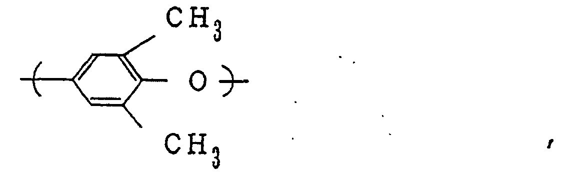 poly(phenylene ether) resins whose impact resistance and moldability have been improved by addition of minor amounts of a polystyrene or a styrene-butadiene elastomer, syndiotactic polystyrene synthesized under structural control with a metallocene catalyst, 4 methylpentene resin having the following unit structure: 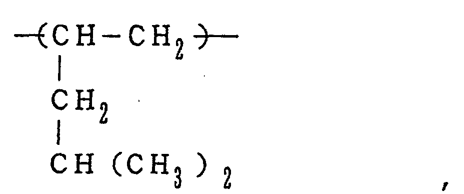 cyclopolyolefin resins comprising cyclic olefins as a constituent, such as polynorbornene resin having the following unit structure: 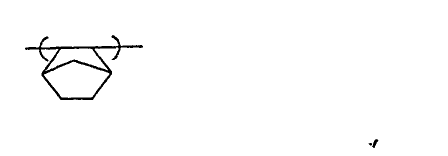 heat-resistant ABS resin whose thermal deformation temperature has been improved by copolymerization with maleimide, heat-resistant polyamide resins such as polyamide-4,6 which is a polycondensation product of 1,4-diaminobutane with adipic acid, polyamide-6T which is obtainable from hexamethylenediamine and terephthalic acid, modified polyamide-6T obtainable by using isophthalic acid or adipic acid for part of the terephthalic acid component, polyamide-6/6T which is a copolymer of ∈-caprolactam, hexamethylenediamine and terephthalic acid, polyamide-6, 6/6T which is a copolymer of hexamethylenediamine, adipic acid and terephthalic acid, poly(phenylene sulfide) resin having the following unit structure: 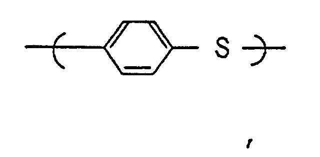 aromatic polysulfone resin comprising the following unit structure: 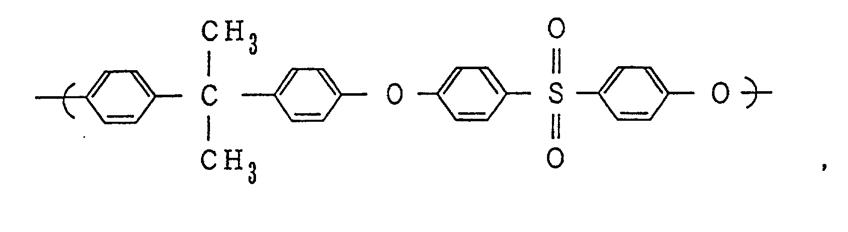 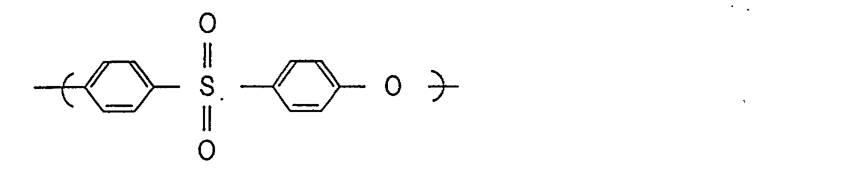 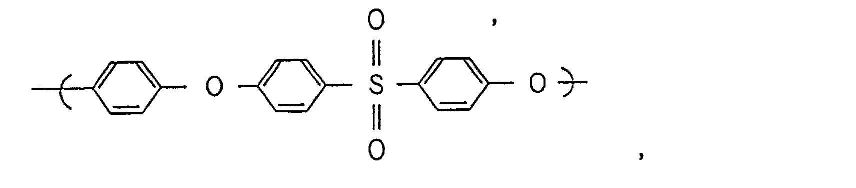 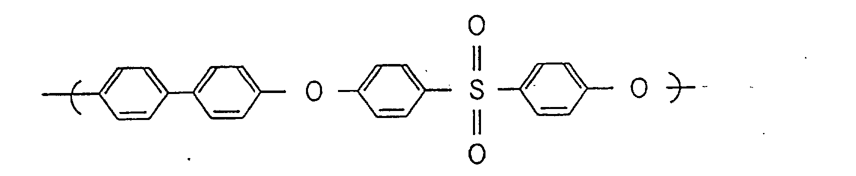 or 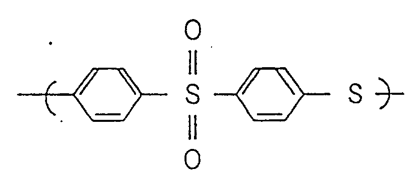 polyetherimide resin having the following unit structure: 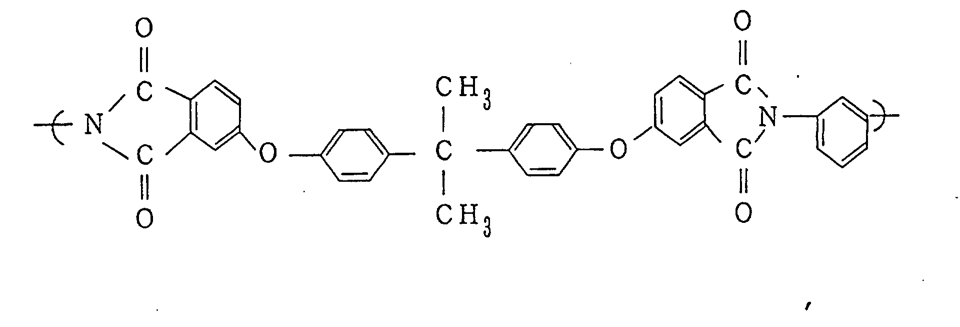 polyetherketone resin having the following unit structure: 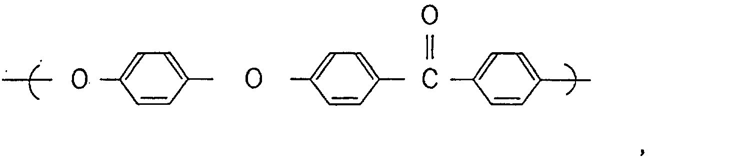 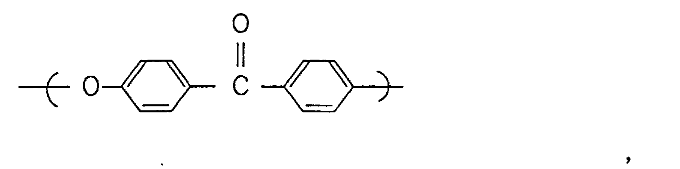 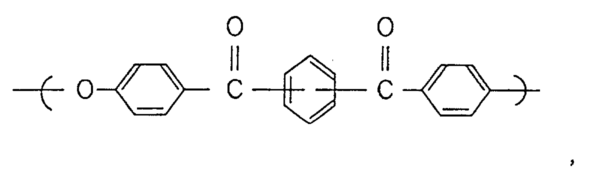 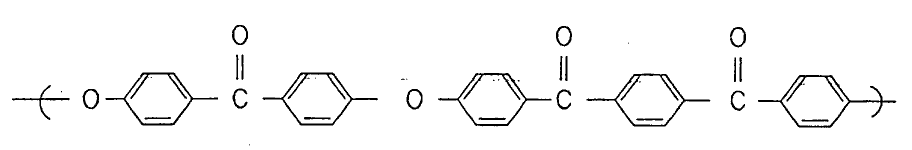 or 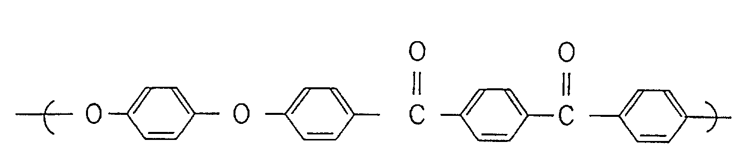 polyethernitrile resin having the following unit structure: 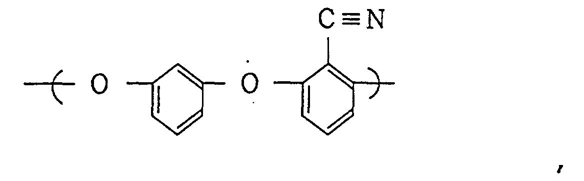 thermotropic liquid crystal polyester resin having the following unit structure: 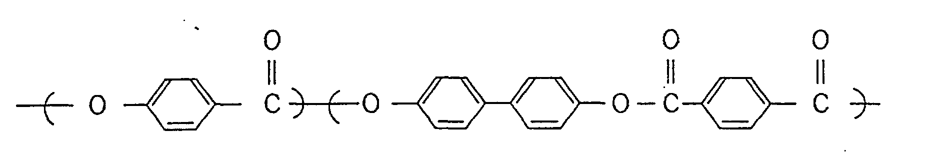 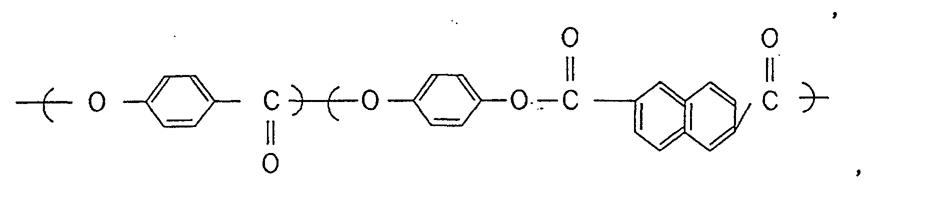 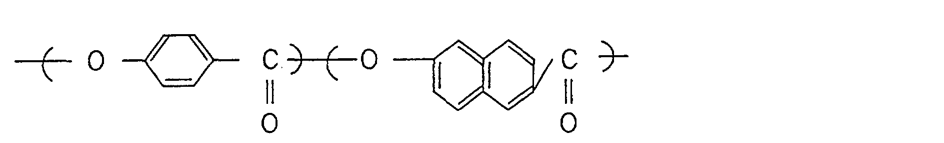 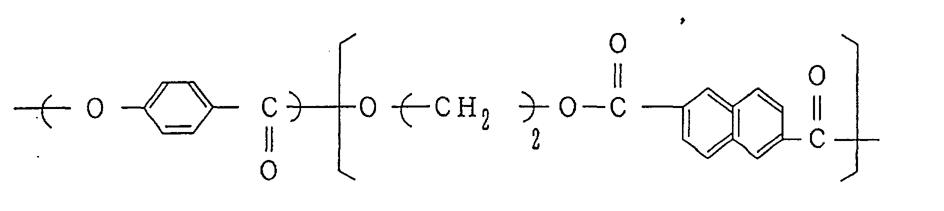 or 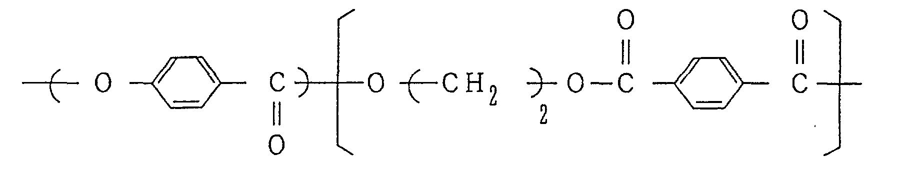 heat-fusible fluororesin such as ethylene-tetrafluoroethylene copolymer, tetrafluoroethylene-hexafluoropropylene copolymer and tetrafluoroethylene-perfluoroalkoxyvinylether copolymer, among others. In this invention, these resins are used singly or in combination.

The thermosetting resin includes phenolic resin, epoxy resin, unsaturated polyester resin, etc. but as the composition of this invention it is particularly preferable to use a resin composition based on a glycidyl ether type heat-resistant polyfunctional epoxy resin and designed for a reduced hot elasticity through modification with phenolic resin as the curing agent and selection of the catalyst.

The reinforcing fiber for use in this invention is a fiber selected from the group consisting of whiskers of the composition represented by the general formula aAₓO_{y}·bB₂O₃ (wherein a, b, A, x and y have the meanings defined hereinbefore) and wollastonite or xonotlite which is a fibrous substance composed predominantly of CaO·SiO₂.

The whiskers of general formula aAₓO_{y}·bB₂O₃ include aluminum borate whiskers corresponding to Al for A and magnesium borate whiskers corresponding to Mg for A, among others.

The aluminum borate whiskers include aluminum borate whiskers of the formula 9Al₂O₃·2B₂O₃ and aluminum borate whiskers of the formula 2Al₂O₃·B₂O₃. These whiskers invariably occur as white acicular crystals (needles) and can be easily produced by, for example, heating at least one species selected from among aluminum hydroxide and inorganic salts of aluminum and at least one species selected from the oxide, oxoacid and alkali metal salts of boron in the presence of at least one fusing agent selected from among the sulfates, chlorides and carbonates of alkali metals at a firing temperature of 600-1200°C for interaction and crystal growth.

The aluminum borate whiskers of the formula 9Al₂O₃·2B₂O₃ are whiskers with a true specific gravity of 2.93-2.95 and a melting point of 1420-1460°C and are preferably of a grade produced at a firing temperature of 900-1200°C. The aluminum borate whiskers of the formula 2Al₂O₃·B₂O₃ have a true specific gravity of 2.92-2.94 and a melting point of 1030-1070°C and are preferably whiskers produced at a firing temperature of 600-1000°C.

The aluminum borate whiskers commercially available today include those of the formula 9Al₂O₃•2B₂O₃ (Alborex G, Shikoku Chemical Industrial) which has an average fiber diameter of 0.5-1 µm and an average fiber length of 10-30 µm.

The magnesium borate whiskers specifically include magnesium borate whiskers of the formula 2MgO·B₂O₃. Whiskers of this type occur as white acicular crystals and can be easily produced by heating a magnesium donor selected from among the oxide, hydroxide and inorganic salts of magnesium and a boron donor selected from among the oxide, oxoacid and alkali metal salts of boron in the presence of at least one fusing agent selected from among sodium halides and potassium halides at a temperature of 600-1000°C. The magnesium borate whiskers of the formula 2MgO·B₂O₃ are preferably whiskers with a true specific gravity of 2.90- 2.92 and a melting point of 1320 - 1360°C.

These aluminum borate whiskers and/or magnesium borate whiskers can be industrially made available in the fiber diameter range of 0.05 - 5 µm and the fiber length range of 2 - 100 µm and all of such products can be used in this invention. However, from the standpoint of ease of production, whiskers in the fiber diameter range of 0.1 - 2 µm and fiber length range of 10 - 50 µm are suitable.

The fibrous substance composed predominantly of CaO·SiO₂ includes wollastonite of the formula CaO·SiO₂ and xonotlite of the formula 6CaO·6SiO₂·H₂O, among others. Wollastonite is a natural substance occurring as white acicular crystals and, regardless of fibrous form or block form, wollastonite can be used as it is or after crushing and size-selection. Synthetic wollastonite can of course be employed.

The above-mentioned fibrous substance varies in aspect ratio according to the crushing method used and the origin or source but generally β-wollastonite, which has a large aspect ratio, is preferred in view of its greater reinforcing effect.

For improved mechanical properties and thermal characteristics of the final composition, it is preferable to employ a fine and elongated wollastonite in which (a) component(s) having an aspect ratio of 6 or more accounts for at least 60 weight %, preferably not less than 80 weight %, and (a) component(s) having a fiber length of not more than 5 µm accounts for at least 80 weight %, preferably not less than 95 weight %. The elongated but coarse wollastonite which contains fibers measuring 6 µm or more in diameter in a proportion of 80 weight % or more even though it contains fibers with aspect ratios not less than 10 in a proportion of 60 weight % or more- tends to break during compounding with the resin and can hardly insure a good balance between mechanical and thermal characteristics.

Some of the wollastonite products available commercially today meet the above requirements and their average fiber diameter and length are 2.0 µm and 25 µm, respectively. Since the proportion of individual fibers measuring 5 µm or less in diameter accounts for not less than 95 weight % and the proportion of fibers having aspect ratios not smaller than 6 accounts for 90 weight %, they are quite satisfactory in reinforcing effect and surface smoothness.

On the other hand, xonotlite is a fibrous calcium silicate of the chemical formula 6CaO·6SiO₂·H₂O and varieties with average fiber diameters in the range of 0.5 - 1 µm, average fiber lengths in the range of 2 - 5 µm and aspect ratios in the range of 2 - 15 have already been synthesized. Unlike wollastonite, xonotlite contains water of crystallization but it was discovered that as far as dielectric characteristics are concerned, this substance produces effects similar to the effects of wollastonite. In regard of reinforcing effect, too, it was found that by employing a species having an aspect. ratio as large as possible (preferably 6 or more), improvements in mechanical properties and heat resistance (thermal deformation temperature) can be realized.

It is only sufficient that at least one member of the group consisting of whiskers of the general formula aAₓO_{y}·bB₂O₃, wollastonite fibers and xonotlite fibers be included, as a dominant fiber component, in the fiber reinforcement in the practice of this invention. Its proportion is not so critical but should generally be not less than 50 weight % and preferably not less than 80 weight %. Within the limits not adversely affecting the effect of this invention, such other reinforcing fibers as glass fiber, carbon fiber, milled glass fiber and alkali metal titanate whiskers, may also be contained.

As regards the amount of said fiber with respect to said thermoplastic or thermosetting resin, it is essential that the fiber be added in a proportion of 5 - 60% based on the combined weight of the resin and fiber (resin composition). If the proportion of fiber is less than 5%, no sufficient improvements will be realized, namely a sufficient decrease in dielectric loss tangent and sufficient increases in mechanical properties and resistance to thermal deformation. Conversely, if the limit of 60% is exceeded, the disadvantage occurs that the fibers can hardly be compounded with the molten thermoplastic resin or dispersed in the solution of the thermosetting resin and this compounding or dispersing operation results in a viscosity increase to seriously interfere with the molding operation. In the practice of this invention, the fibers are preferably used in a proportion of 10 - 40%.

Within the range not contrary to the object of this invention, a variety of conventional additives, for example a finely divided filler such as talc and calcium pyrophosphate, an antioxidant, a heat stabilizer, an ultraviolet absorber, a coloring agent such as dyes and pigments, a lubricant such as fluororesin, a parting agent and an antistatic agent, can be incorporated in suitable amounts.

The resin composition of this invention can be produced by a liberal choice of the per se known production techniques. For example, when a thermoplastic resin is employed, said additives are first incorporated in the resin by means of a tumbler or ribbon mixer. Then, using a twin-screw extruding machine, a predetermined amount of said fiber is fed to the resin matrix in the course of compounding and pelletized. In the case of a thermosetting resin, a super-mixer or a kneader is charged with the green (uncured) resin and the fiber and additives are then added to the resin, after which a curing agent and a catalyst are added, with the product being withdrawn in a paste form.

In accordance with this invention, there is provided an electronic device resin composition having low dielectric constant, low dielectric loss tangent and high heat resistance characteristics which are much demanded in electric and electronic circuit board materials. The electronic device resin composition of this invention can be used in a broad spectrum of applications ranging, for example, from semiconductor packages such as chip carriers or pin-grid arrays, to bases for resistors, switches, capacitors or photosensors, to various structural parts such as IC sockets or connectors. In particular, this resin composition is useful for the fabrication of printed circuit boards for high-frequency devices represented by satellite broadcasting-related equipment and information processing equipment components. In the field of home appliances, the resin composition finds application in various vessels compatible with electronic cookers.

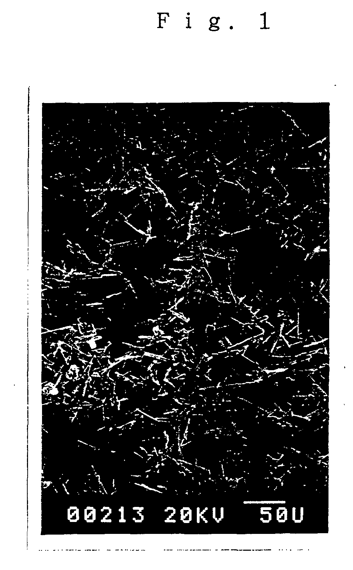

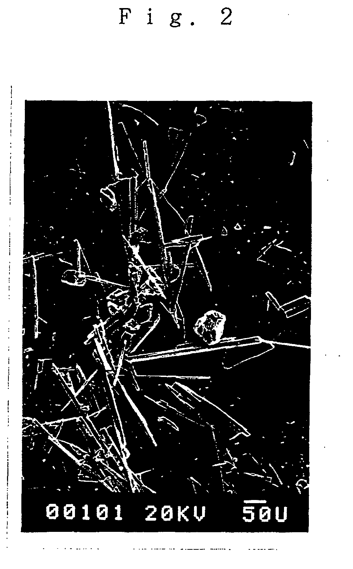

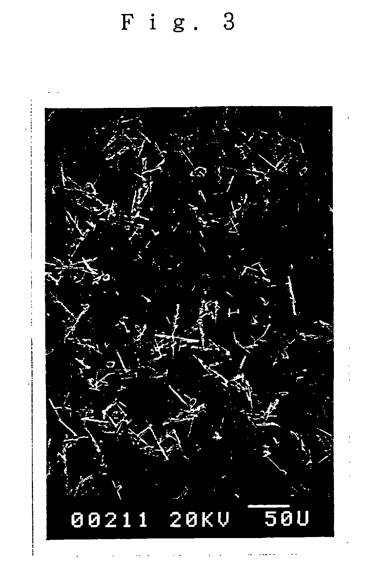

Fig. 1 is a photomicrogram showing the morphology of the wollastonite A fiber used in the examples. Fig. 2 is a photomicrogram showing the morphology of the wollastonite B fiber used in the examples. Fig. 3 is a photomicrogram showing the morphology of the wollastonite C fiber used in the examples.

The following examples and comparative examples are intended to describe this invention in further detail. It should be understood that both dielectric constant and dielectric loss were determined according to JIS K-6911, tensile strength according to JIS K-7113, flexural strength and flexural modulus of elasticity according to JIS K-7203, and Izod strength (notched) according to JIS K-7110.

### Examples 1 - 5 and Comparative Examples 1 & 2

Pellets were provided by using, as the poly(phenylene ether) resin, Xylon PXL-2502 (Asahi Chemical Industry Co., Ltd.) having a thermal deformation temperature of 150°C under a load of 18.6 kgf/cm² and, as reinforcing whiskers, 15 weight % or 30 weight % of Alborex G (Shikoku Chemicals Corp.; aluminum borate whiskers) having a composition of 9Al₂O·2B₂O₃, a fiber diameter of 0.5 - 1.0 µm and a fiber length of 10 - 30 µm, Suanite (Otsuka Chemical Co., Ltd.; magnesium borate whiskers) having a composition of 2MgO·B₂O₃, a fiber diameter of 0.5 - 2.0 µm and a fiber length of 20 - 40 µm, or, as control, TISMO-D (Otsuka Chemical Co., Ltd.; potassium titanate whisker) having a composition of K₂O·8Tio₂, an average fiber diameter of 0.4 µm and an average fiber length of 15 µm. Using a twin-screw extruder (Ikegai Iron Works, PCM45) at a cylinder temperature of 300°C, PXL 2502 was first melted and the whiskers were then added in the course of compounding (side feed system), followed by strand cutting. Each of these kinds of pellets was injection-molded using an injection machine (Nissei Resin Industries, FS-150) at a cylinder temperature of 320°C, a die temperature of 100°C and an injection pressure of 800 kg/cm² G. The physical properties of the resin moldings thus obtained were determined.

The results are presented in Table 1.

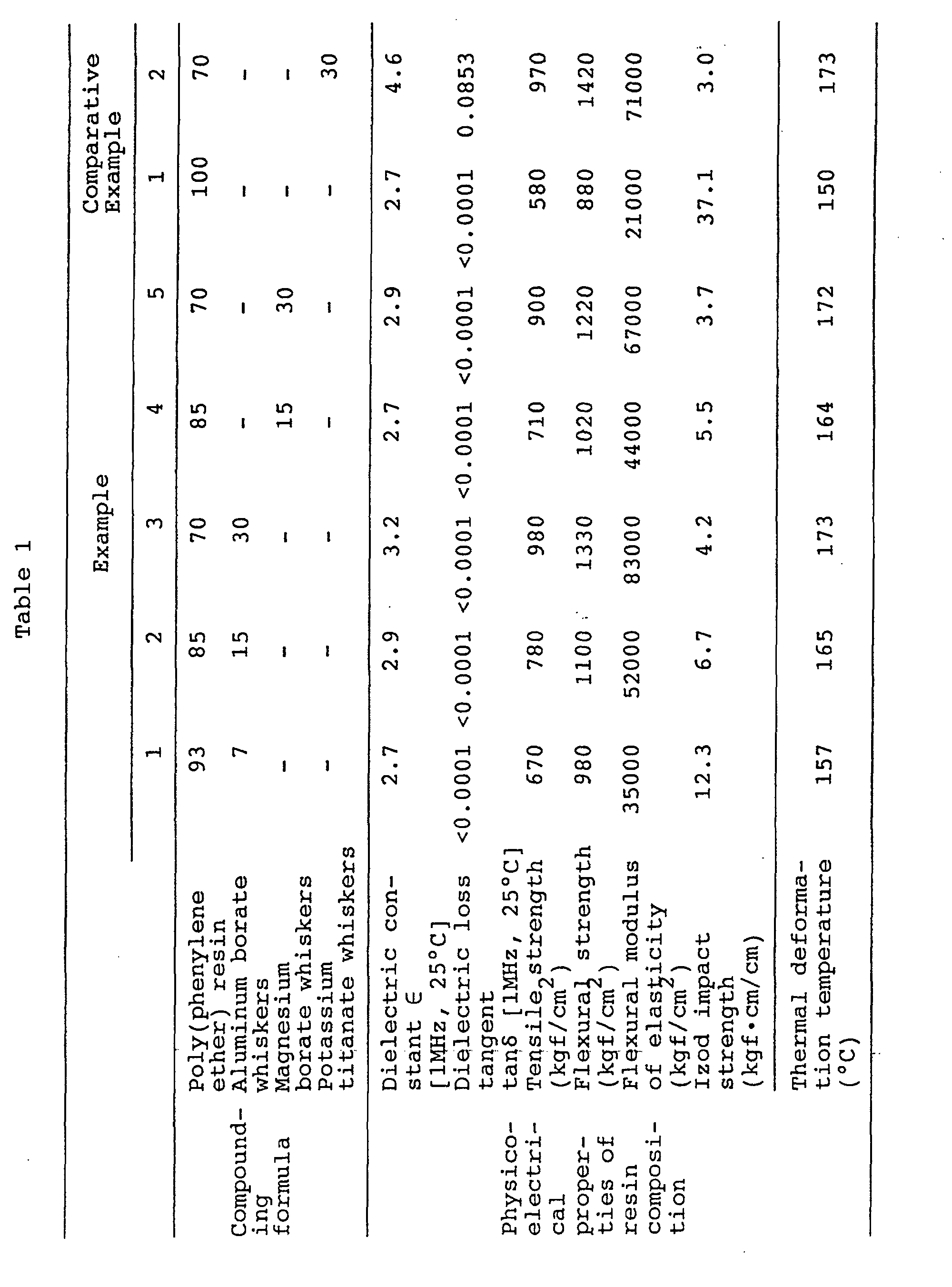

While poly(phenylene ether) resin inherently has very low dielectric constant and dielectric loss tangent values as seen from Table 1 and, as such, is an optimal matrix resin for circuit board use (Comparative Example 1), it is apparent from Examples 1 - 5 and Comparative Example 2 that incorporation of a reinforcing fiber (whiskers) is effective for enhancing the heat resistance and mechanical properties.

However, it can be seen that whereas the addition of potassium titanate whiskers, which are frequently utilized as ceramic whiskers, in a proportion of 30 weight % resulted in the dielectric constant and dielectric loss tangent of as high as 4.6 and 0.0853, respectively, the addition of aluminum borate whiskers and magnesium borate whiskers improved the mechanical properties and thermal deformation temperature while holding the dielectric constant as low as 3.2 and 2.9, respectively, and the dielectric loss tangent as low as not greater than 0.0001 in both cases.

### Examples 6 - 11 and Comparative Examples 3 - 5

Resin compositions (pellets) were prepared in the same manner as Examples 1 - 5 except that Ultem #1010-1000 (distributor: GE Plastics Japan) was used as the polyetherimide resin at an extruder cylinder temperature of 340°C and Vectra C950 (distributor: Poly plastics) was used as the thermotropic liquid crystal polyester as an extruder cylinder temperature of 310°C. The polyetherimide resin composition was injectionmolded at a cylinder temperature of 370°C, a die temperature of 120°C and an injection pressure of 700 kgf/cm² G and the thermotropic liquid crystal polyester resin composition was similarly molded at a cylinder temperature of 330°C, a die temperature of 120°C and an injection pressure of 800 kgf/cm² G. The physical properties of the respective products were determined. The results for the polyetherimide resin composition are shown in Table 2 and those for the thermotropic liquid crystal polyester resin are shown in Table 3. It should be understood that neutral Tismo N (K₂O·6TiO₂, Otsuka Chemical Co., Ltd.) was used as the potassium titanate whisker for the purpose of preventing an increase of viscosity on melting of the polyetherimide resin and for the purpose of preventing alkaline decomposition in the case of the thermotropic liquid crystal polyester.

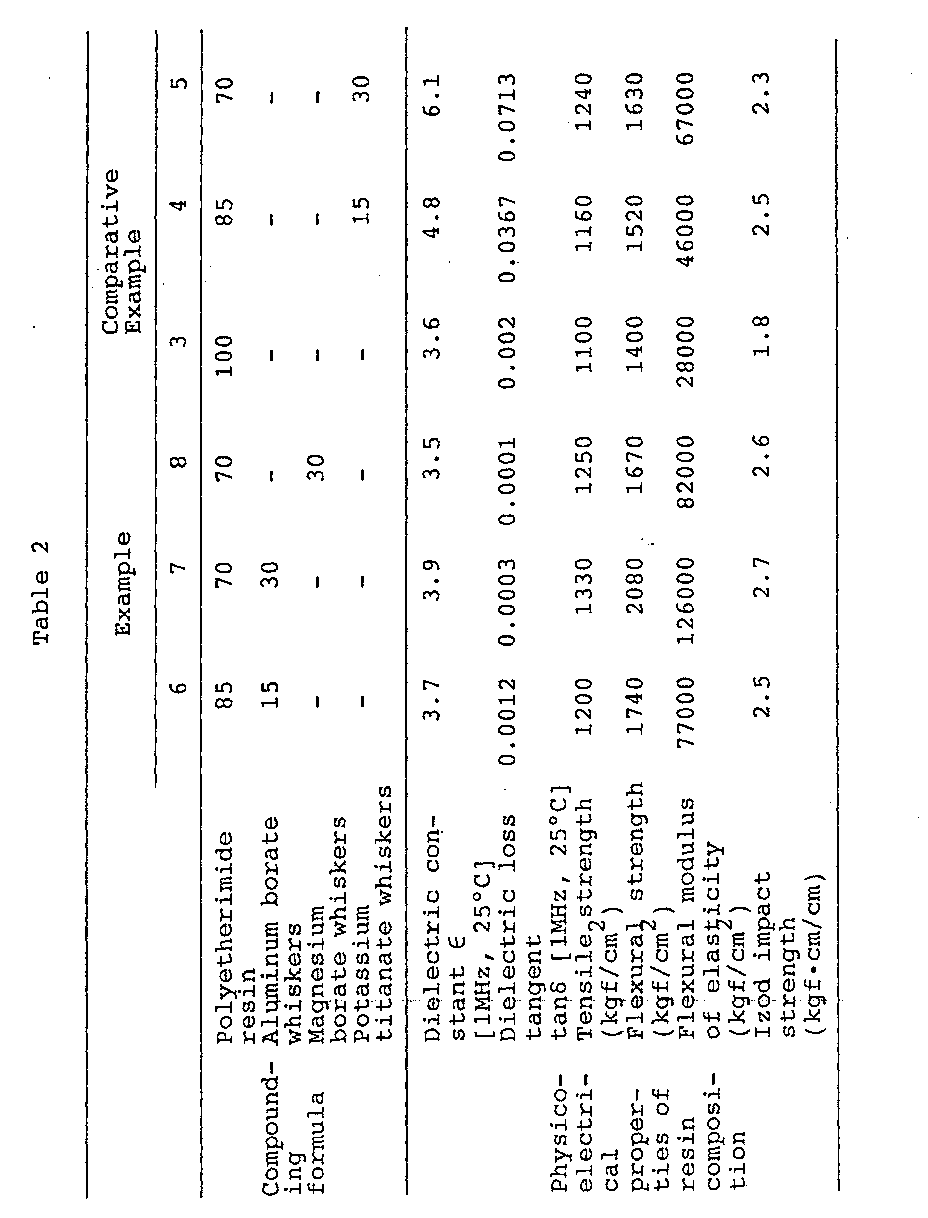

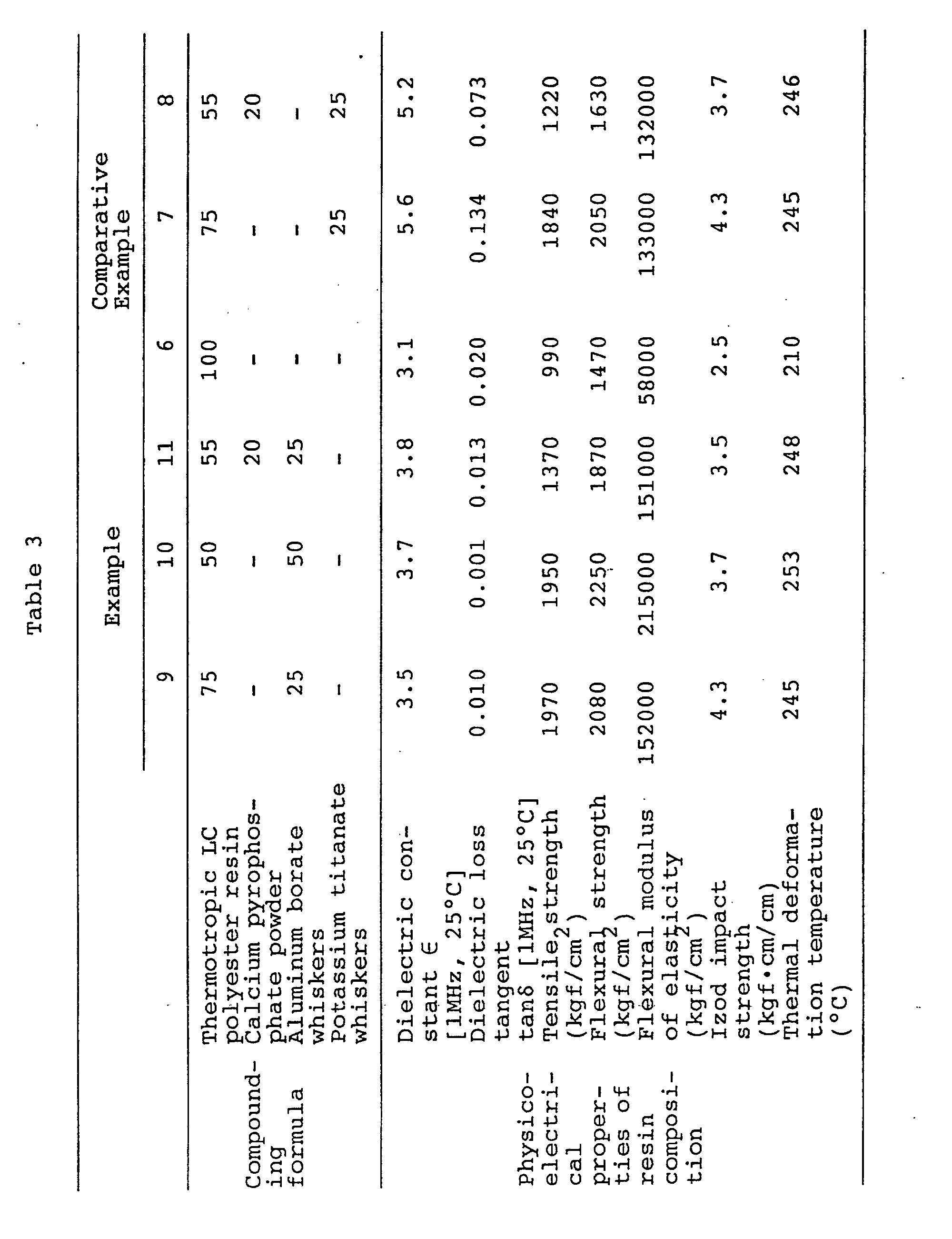

Referring to Table 2, while the reinforcing effect of whiskers is comparatively small on the polyetherimide resin which is amorphous, the reinforcing effect of aluminum borate whiskers is outstanding. The effects on dielectric characteristics are also worth attention. Thus, the dielectric constant is considerably increased with an increasing proportion of whiskers in the case of potassium titanate whiskers. In the case of aluminum borate whiskers and magnesium borate whiskers, the dielectric constant is little increased and the dielectric loss tangent was considerably diminished, compared with the resin alone (Comparative Example 3), with an increasing proportion of the whiskers, for example by one digit at the addition level of 30 weight %, in particular, so that very satisfactory characteristics for a circuit board can be implemented.

It is also apparent from Table 3 that compared with the polyetherimide which is an amorphous resin, the thermotropic liquid crystal polyester resin is more receptive to the reinforcing effect of whiskers because of its crystalline structure. In this case, too, the incorporation of potassium titanate whiskers resulted in a fairly increased dielectric constant and an increase of one digit in dielectric loss tangent. In contrast, with aluminum borate whiskers, the dielectric constant was increased only in a minor degree and the dielectric loss tangent rather decreased with an increasing proportion of the whisker as compared with the case of the resin alone. The calcium pyrophosphate powder (average particle diameter ca. 10 µm, Taihei Chemical Industrial) was added as an etching auxiliary agent for the thermotropic liquid crystal polyester resin. With respect to potassium titanate whiskers, the agent improves dielectric characteristics in a certain measure. However, in the case of aluminum borate whiskers, it tends to decrease the dielectric characteristics.

### Example 12 and Comparative Examples 9 - 11

A phenol-epoxy resin (EPCLON 850, Dainippon Ink And Chemicals) was used as the thermosetting resin and 50 weight % of an E glass short fiber (Nippon Electric Glass Fiber) measuring 13 µm in diameter and 1.5 mm long, a potassium titanate fiber (Otsuka Chemical, Tismo-D), or aluminum borate whiskers (Shikoku Chemicals, Alborex G) as the filler. After the fiber had been well dispersed in the resin, metaxylinediamine was added at the rate of 15 phR (15 parts by weight with respect to 100 parts by weight of the epoxy resin). The composition was further stirred, degassed under reduced pressure and cast onto a Teflon sheet surrounded by a 3 mm-thick spacer. The casting was allowed to stand at ambient temperature for 3 hours, after which it was cured at 130°C for 3 hours. The flexural strength and deflection temperature under load (18.5 kgf/cm²) were determined according to JIS K-6911 and the surface roughness was measured using Surfcom 300B (Tokyo Seimitsu Co., Ltd.) and expressed in center mean roughness Ra. The results are presented in Table 4.

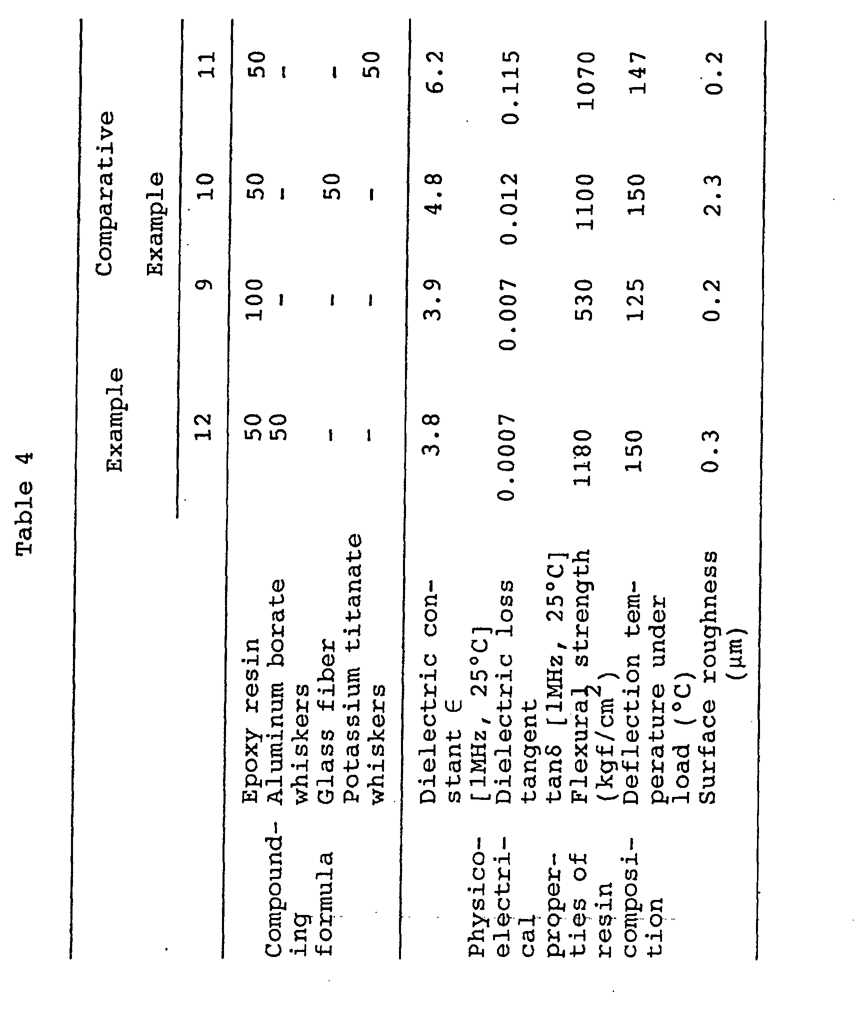

It can be seen from Table 4 that in the case of thermosetting resin, the effect of aluminum borate whiskers on dielectric characteristics is superior to the corresponding effect of glass fiber which is conventionally used (not to speak of potassium titanate whiskers) and that whereas the dielectric constant and dielectric loss tangent values obtainable with other reinforcing materials are inferior to the values found without the use of any reinforcing material, the use of aluminum borate whiskers results in dielectric characteristics very suited to a circuit board material, with the dielectric constant being comparable to or somewhat smaller and the dielectric loss tangent being reduced by one digit.

In terms of surface roughness, too, it was found that a submicron smoothness characteristic of whiskers can be realized, with consequent great advantages in the adhesion of copper foil and circuit printability.

### Examples 13 - 16 and Comparative Examples 12 - 13

As the cyclic polyolefin resin, Zeonex 480 (Nippon Zeon) having a thermal deformation temperature of 123°C under a load of 18.6 kgf/cm² was provided and as the wollastonite, 15 or 30 weight % of a wollastonite available commercially in the United States of America and having an average fiber diameter of 2.0 µm and an average fiber length of 25 µm (hereinafter referred to as 'wollastonite A'), Daiken Fiber Nite (manufactured in China, distributed by Sanyo Kogyo) having an average fiber diameter of 6.0 µm and an average fiber length of 132 µm (hereinafter referred to as 'wollastonite B'), WICROLL-10 (Partek Minerals) with an average fiber diameter of 4.5 µm and an average fiber length of 13 µm (hereinafter referred to as 'wollastonite C'), or, as a control, TISMO-D (Otsuka Chemical Co., Ltd., potassium titanate whisker) having a formulation of K₂O·8TiO₂, an average fiber diameter of 0.4 µm and an average fiber length of 15 µm was provided. In a twin-screw extruder (Ikegai Iron Works, PCM45) at a cylinder temperature of 300°C, Zeonex 480 was melted and the fiber or whiskers were added (by the side feed method) in the course. The pellets obtained by strand cutting were injection-molded using an injection machine (Nissei Resin Industries, FS-150) at a cylinder temperature of 290°C, a die temperature of 130°C and an injection pressure of 800 kg/cm² G. The physical properties of the product were then determined.

The results are shown in Table 5.

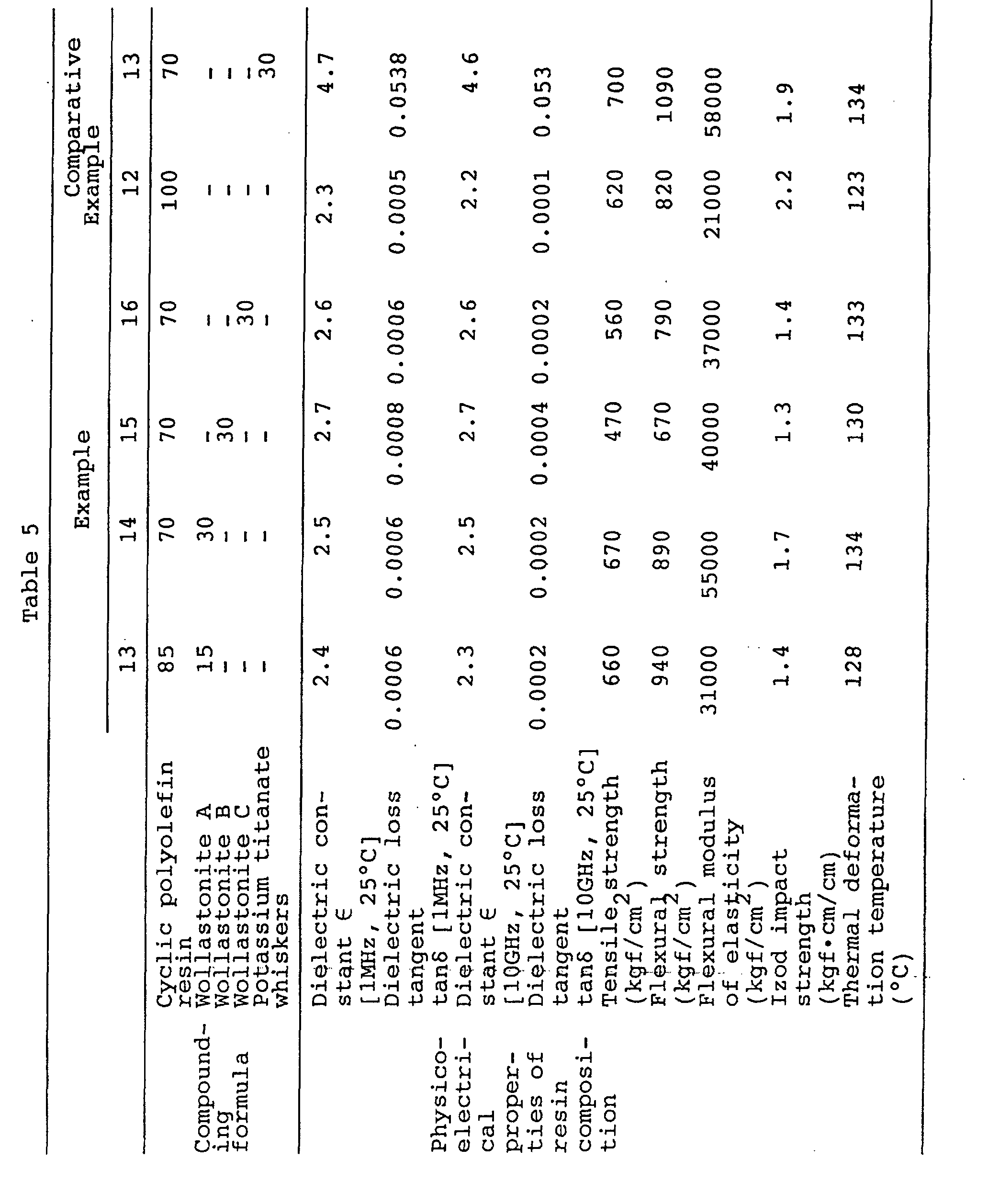

It is apparent from Table 5 that while the cyclic polyolefin resin is intrinsically very low in dielectric constant and dielectric loss tangent and, as such, is very suited as a circuit board matrix resin (Comparative Example 12), incorporation of reinforcing fibers is effective in enhancing its resistance to heat (Examples 13 - 16 and Comparative Example 13).

When potassium titanate whiskers which are conventionally used as a resin-reinforcing filler are added in a proportion of 30 weight %, the dielectric constant and dielectric loss tangent at 1 MHz are fairly large, i.e. 4.7 and 0.0538, respectively. When wollastonite is used (Examples 14 - 16), the dielectric constant is 2.5 - 2.7 and the dielectric loss tangent is 0.0006 - 0.0008, indicating that the thermal deformation temperature and flexural modulus of elasticity can be improved while the low dielectric constant and low dielectric loss tangent are sustained. The dielectric characteristics at 10 GHz were determined by the cavity perturbation method. As found, wollastonite (Examples 14 - 16) provided for satisfactory dielectric characteristics even in the 10 GHz band, with the dielectric constant of 2.5 - 2.7 and the dielectric loss tangent of 0.0002 - 0.0004, indicating that these products are of great utility value as high-frequency materials.

The reinforcing effect of wollastonite varies with its morphology. In Examples 13 and 14 where a wollastonite A comprising fibers with aspect ratios not less than 6 in a proportion of not less than 90 weight % and those with diameters not greater than 5 µm in a proportion not less than 95 weight % was used, greater improvements were realized in mechanical properties as compared with wollastonite C which is somewhat larger in fiber diameter and smaller in aspect ratio.

In connection with fiber morphology, when a coarse wollastonite comprising fibers with aspect ratios not smaller than 10 in a proportion of at least 60 weight % but fibers with diameters not less than 6 µm in a proportion of at least 80 weight % was employed as in Example 15, it was difficult to insure sufficient mechanical strength and desirable thermal characteristics.

### Examples 17 - 22 and Comparative Examples 14 - 19

A resin composition (pellets) was prepared using Ultem #1010-1000 (distributor: GE Plastics Japan Ltd.) as the polyetherimide resin at an extruder cylinder temperature of 340°C or using Vectra C950 (distributor: Polyplastics), a thermotropic liquid crystal polyester, at an extruder cylinder temperature of 310°C in otherwise the same manner as Examples 13 - 16. The polyetherimide resin composition was injection-molded at a cylinder temperature of 370°C, a die temperature of 120°C and an injection pressure of 700 kgf/cm² G and the thermotropic liquid crystal polyester resin composition at a cylinder temperature of 330°C, a die temperature of 120°C and an injection temperature of 800 kgf/cm² G. Then, the physical properties of the respective resin products were determined. The results for the polyetherimide resin composition are shown in Table 6 and the results for the thermotropic liquid crystal polyester resin composition in Table 7. In these procedures, as potassium titanate whiskers, neutral TISMO-N (K₂O·6TiO₂, manufacturer: Otsuka Chemical Co., Ltd.) was added to the polyetherimide resin for the purpose of preventing a viscosity increase in melting and to the thermotropic liquid crystal polyester for the prevention of alkali decomposition.

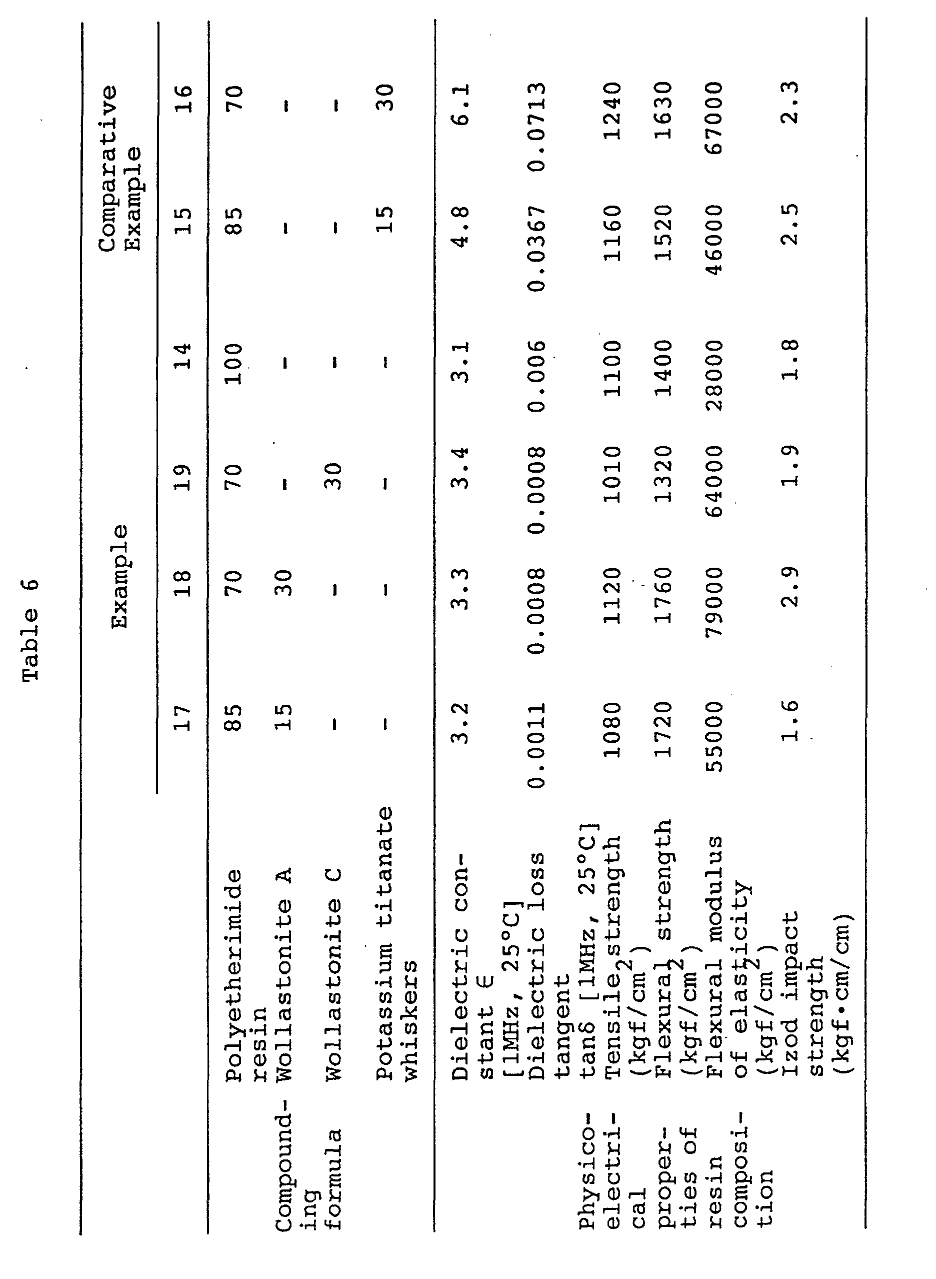

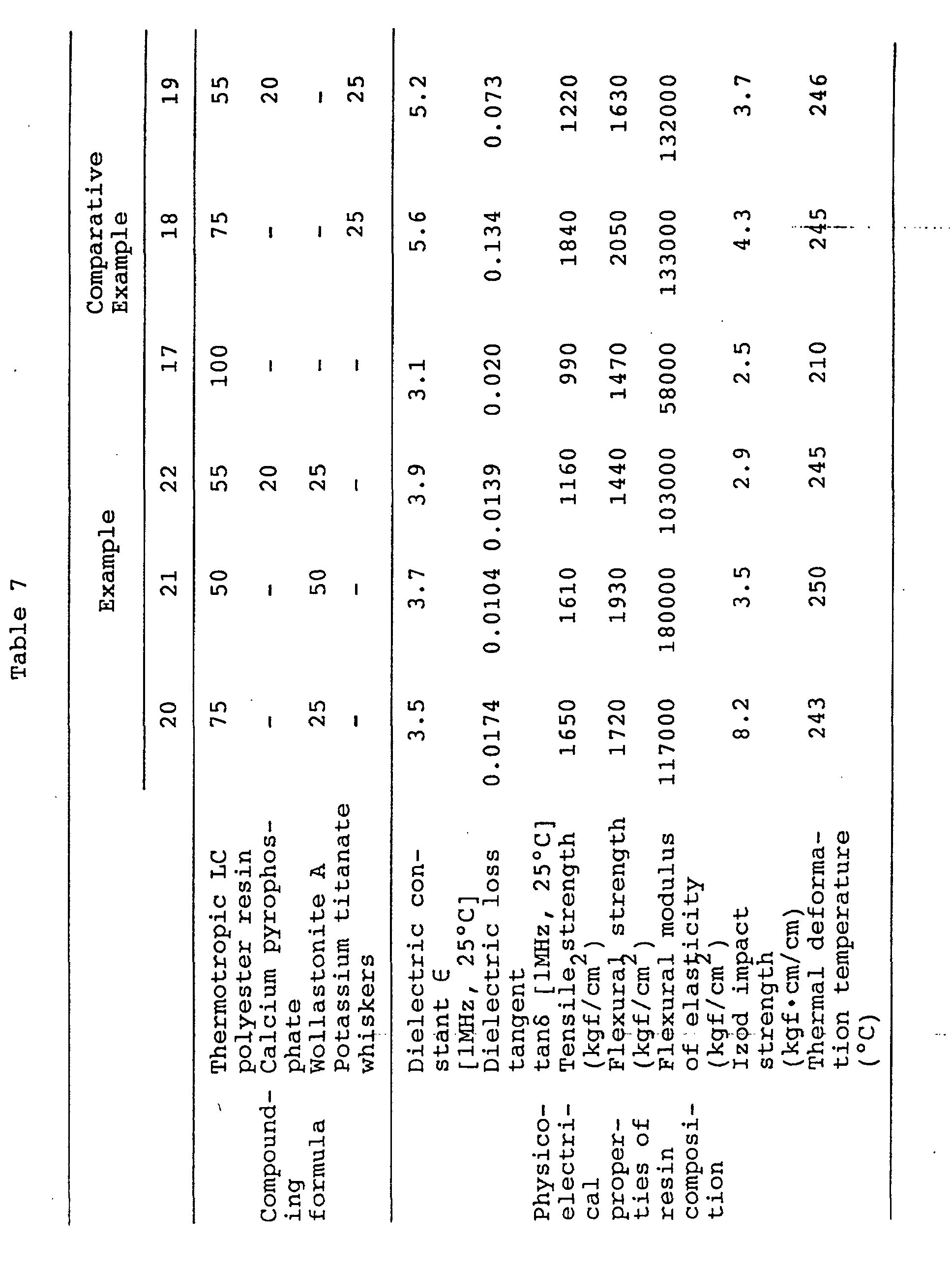

While the reinforcing effect of these fibers on the polyetherimide resin is comparatively minor because the matrix is an amorphous resin, it is clear from Table 6 that whereas the dielectric constant was significantly increased with an increasing proportion of potassium titanate whiskers, the addition of wollastonite resulted in substantially no increase in dielectric constant and that as far as dielectric loss tangent is concerned, an increasing amount of wollastonite resulted in a progressive decrease as compared with the case of the resin alone and particularly at the addition level of 30 weight %, the tangent value decreased by one digit, indicating that very satisfactory characteristics are realized for electric/electronic circuit board use.

It is apparent from Table 7 that because of the crystalline structure of the thermotropic liquid crystal polyester resin, the reinforcing effect of fibers is greater than that on the amorphous polyetherimide resin. In this case too, addition of potassium titanate whiskers resulted in a substantial increase in dielectric constant and an increase of one digit in dielectric loss tangent. In contrast, when wollastonite was added, the dielectric constant was increased only in a minor degree and the dielectric loss tangent was reduced in proportion with the level of addition and was smaller than the value found for the resin alone. Incidentally, calcium pyrophosphate powder (average particle diameter ca. 10 µm; manufacturer; Taihei Chemical Industrial) was added as an etching auxiliary for the thermotropic liquid crystal polyester resin. This agent improves dielectric characteristics somewhat in the case of potassium titanate whiskers but tends to affect dielectric characteristics adversely in the case of wollastonite.

### Examples 23 and 24, and Comparative Examples 20 - 22

To a phenol-epoxy resin (EPCLON 850, Dainippon Ink and Chemicals), as the thermosetting resin, was added 50 weight % of an E glass short staple fiber with a diameter of 13 µm and 1.5 mm in length (Nippon Electric Glass Fiber), a potassium titanate fiber (Otsuka Chemical, Tismo-D), the same wollastonite A as used in Examples 1 and 2, or a xonotlite with an average fiber diameter of 0.7 µm and an average fiber length of 5.2 µm, as the reinforcing fiber, and after thorough mixing for dispersion, metaxylinediamine as the curing agent was added at the rate of 15 phR (15 parts by weight with respect to 100 parts by weight of the epoxy resin). The mixture was further stirred, degassed under reduced pressure and cast on a Teflon sheet partitioned by a 3 mm-thick spacer. The casting was allowed to stand at ambient temperature for 3 hours, after which it was cured at 130°C for 3 hours. The flexural strength and deflection temperature under load (load: 18.5 kfg/cm²) were determined according to JIS K-6911 and the surface roughness was determined using Surfcom 300B (Tokyo Seimitsu Co., Ltd.) and expressed in center mean roughness Ra. The results are presented in Table 8.

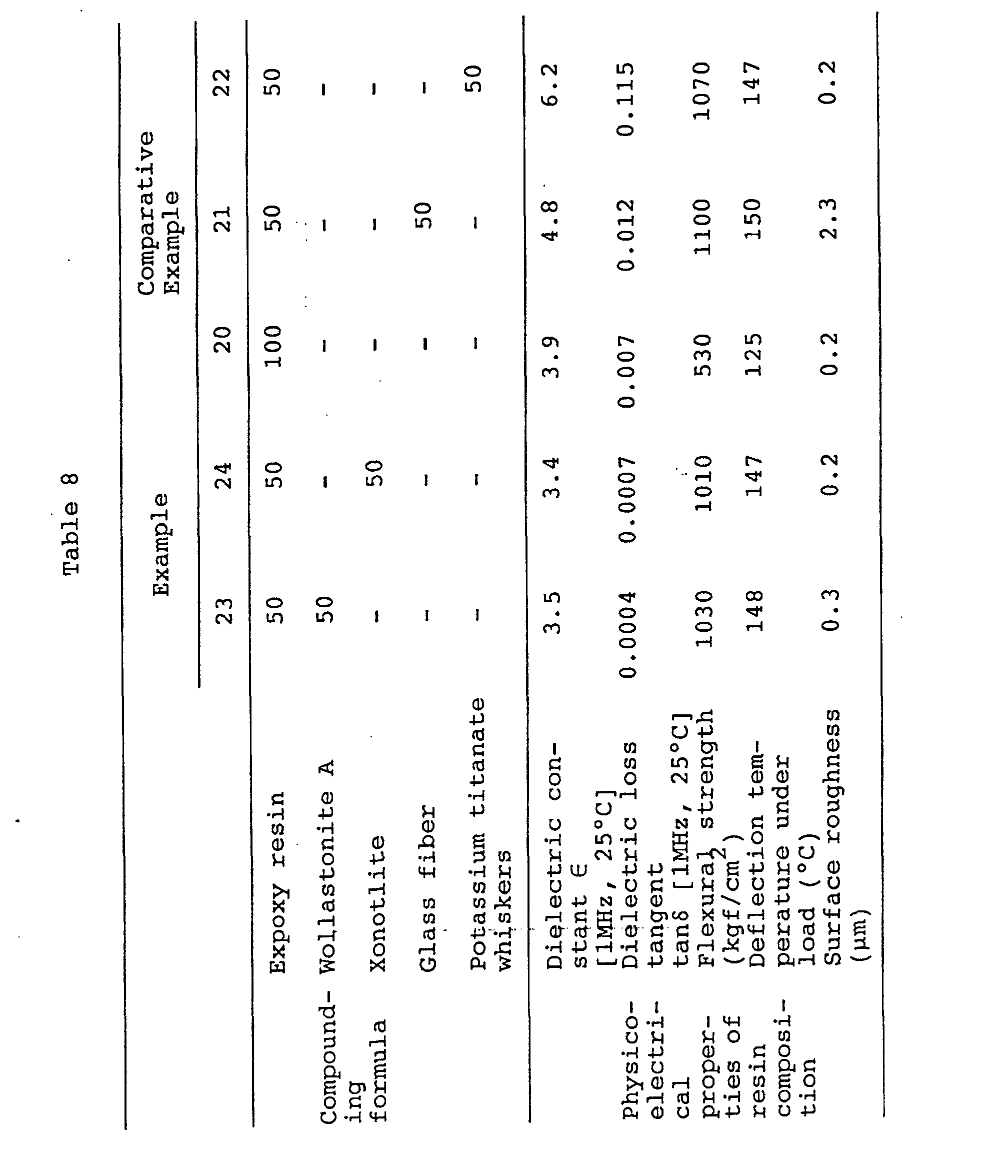

It is apparent from Table 8 that even in the case of a thermosetting resin, the dielectric characteristics obtained with wollastonite or xonotlite are superior to those obtained with the conventional glass fiber (not to speak of potassium titanate whiskers) and that whereas the dielectric constant and dielectric loss tangent values obtained with other reinforcing materials are inferior to those found without addition of a reinforcement, wollastonite and xonotlite are conducive to very excellent dielectric characteristics for circuit board materials, with the dielectric constant being comparable to or slightly smaller and the dielectric loss tangent being reduced by one digit.

As to surface roughness, too, a very satisfactory surface of the submicron order was obtained, thus being found to be very advantageous in terms of adhesion to copper foil as well as in circuit printability.

## Claims

1. A method for reducing the dielectric loss tangent of a thermoplastic resin or a thermosetting resin, comprising incorporating into the resin at least one of the fibers selected from wollastonite, xonotlite and whiskers in a proportion of 5 to 60% by weight, based on the combined weight of the resin and the fibers, said whiskers being represented by the formula aAₓO_{y}·bB₂O₃ (wherein a and b independently represent a whole number of 1 to 9; A represents a divalent or trivalent metal; and x and y independently represent a whole number of 1 to 3) and wollastonite and xonotlite being fibrous substances composed predominantly of CaO·SiO₂.

2. The method according to claim 1 wherein the thermoplastic resin is at least one resin selected from poly(phenylene ether) resin, syndiotactic polystyrene, 4-methylpentene resin, cyclic polyolefin resin, heat-resistant ABS resin, heat-resistant polyamide resin, poly(phenylene sulfide) resin, aromatic polysulfone resin, polyetherimide resin, polyetherketone resin, polyethernitrile resin, thermotropic liquid crystal polyester resin and heat-fusible fluororesin.

3. The method according to claim 1 wherein the thermosetting resin is at least one resin selected from phenolic resin, epoxy resin and unsaturated polyester resin.

4. The method according to any one of claims 1-3 wherein the whiskers of the formula aAₓO_{y}·bB₂O₃ are aluminum borate whiskers of the formula 9Al₂O₃·2B₂O₃ or 2Al₂O₃·B₂O₃ or magnesium borate whiskers of the formula 2MgO·B₂O₃ and have fiber diameters in the range of 0.05 to 5 µm and fiber lengths in the range of 2 to 100 µm.

5. The method according to any one of claims 1-3 wherein the wollastonite comprises fibers having aspect ratios not lower than 6 in a proportion of not less than 60 percent by weight and fibers having diameters of not larger than 5 µm in a proportion of not less than 80 percent by weight.

6. The use of at least one fiber material selected from wollastonite, xonotlite and whiskers represented by the formula aAₓO_{y}·bB₂O₃ (wherein a and b independently represent a whole number of 1 to 9; A represents a divalent or trivalent metal; and x and y independently represent a whole number of 1 to 3) for reducing the dielectric loss tangent of a thermoplastic resin or a thermosetting resin.

## Patentansprüche

1. Verfahren zur Verminderung des dielektrischen Verlustfaktors eines thermoplastischen Harzes oder eines wärmehärtbaren Harzes, umfassend die Aufnahme mindestens einer der aus Wollastonit, Xonotlit und Whiskern ausgewählten Fasern in das Harz in einem Anteil von 5 bis 60 Gew.-%, bezogen auf das gemeinsame Gewicht von Harz und Fasern, wobei die Whisker durch die Formel aAₓO_{y}·bB₂O₃ dargestellt sind (worin ä und b unabhängig eine ganze Zahl von 1 bis 9 darstellen, A ein zweiwertiges oder dreiwertiges Metall darstellt und x und y unabhängig eine ganze Zahl von 1 bis 3 darstellen) und Wollastonit und Xonotlit faserartige Substanzen sind, die überwiegend aus CaO·SiO₂ zusammengesetzt sind.

2. Verfahren nach Anspruch 1, worin das thermoplastische Harz mindestens ein aus Poly(phenylenether)-Harz, syndiotaktischem Polystyrol, 4-Methylpenten-Harz, cyclischem Polyolefin-Harz, wärmebeständigem ABS-Harz, wärmebeständigem Polyamid-Harz, Poly(phenylensulfid)-Harz, aromatischem Polysulfon-Harz, Polyetherimid-Harz, Polyetherketon-Harz, Polyethernitril-Harz, thermotropem Flüssigkristall-Polyesterharz und wärmeschmelzbarem Fluorharz ausgewähltes Harz ist.

3. Verfahren nach Anspruch 1, worin das wärmehärtbare Harz mindestens ein aus Phenolharz, Epoxyharz und ungesättigtem Polyesterharz ausgewähltes Harz ist.

4. Verfahren nach irgendeinem der Ansprüche 1 bis 3, worin die Whisker der Formel aAₓO_{y}·bB₂O₃ Aluminiumborat-Whisker der Formel 9Al₂O₃·2B₂O₃ oder 2Al₂O₃·B₂O₃ oder Magnesiumborat-Whisker der Formel 2MgO·B₂O₃ sind und Faserdurchmesser im Bereich von 0,05 bis 5 µm und Faserlängen im Bereich von 2 bis 100 µm aufweisen.

5. Verfahren nach irgendeinem der Ansprüche 1 bis 3, worin der Wollastonit Fasern mit Höhen-Breiten-Verhältnissen von nicht kleiner als 6 in einem Anteil von nicht weniger als 60 Gew.-% und Fasern mit Durchmessern von nicht größer als 5 µm in einem Anteil von nicht weniger als 80 Gew.-% umfaßt.

6. Verwendung mindestens eines Fasermaterials, ausgewählt aus Wollastonit, Xonotlit und Whiskem, die durch die Formel aAₓO_{y}·bB₂O₃ dargestellt sind (worin a und b unabhängig eine ganze Zahl von 1 bis 9 darstellen, A ein zweiwertiges oder dreiwertiges Metall ist und x und y unabhängig eine ganze Zahl von 1 bis 3 darstellen) zur Verminderung des dielektrischen Verlustfaktors eines thermoplastischen Harzes oder eines wärmehärtbaren Harzes.

## Revendications

1. Procédé destiné à réduire le facteur de dissipation diélectrique d'une résine thermoplastique ou d'une résine thermodurcissable, comprenant l'incorporation dans la résine d'au moins une des fibres choisies parmi la wollastonite, la xonotlite et les trichites, dans une proportion de 5% à 60% en poids, sur la base du poids combiné de la résine et des fibres, lesdites trichites étant représentées par la formule aAₓO_{y}·bB₂O₃ (dans laquelle a et b représentent, indépendamment l'un de l'autre, un nombre entier compris entre 1 et 9 ; A représente un métal divalent ou trivalent ; et x et y représentent, indépendamment l'un de l'autre, un nombre entier compris entre 1 et 3) et la wollastonite et la xonotlite étant des substances fibreuses composées principalement de CaO·SiO₂.

2. Procédé selon la revendication 1, dans lequel la résine thermoplastique est au moins une résine choisie parmi une résine poly(éther de phénylène), un polystyrène syndiotactique, une résine de 4-méthylpentène, une résine polyoléfine cyclique, une résine ABS thermorésistante, une résine polyamide thermorésistante, une résine poly(sulfure de phénylène), une résine polysulfone aromatique, une résine polyéthérimide, une résine polyéthercétone, une résine polyéthernitrile, une résine polyester de cristaux liquides thermotropes et une résine fluorée thermofusible.

3. Procédé selon la revendication 1, dans lequel la résine thermodurcissable est au moins une résine choisie parmi une résine phénolique, une résine époxyde et une résine polyester insaturée.

4. Procédé selon l'une quelconque des revendications 1 à 3, dans lequel les trichites de formule aAₓO_{y}·bB₂O₃ sont des trichites de borate d'aluminium de formule 9Al₂O₃·2B₂O₃ ou 2Al₂O₃·B₂O₃ ou des trichites de borate de magnésium de formule 2MgO·B₂O₃ et présentent un diamètre de fibres dans la gamme allant de 0,05 à 5 µm et une longueur de fibres dans la gamme allant de 2 à 100 µm.

5. Procédé selon l'une quelconque des revendications 1 à 3, dans lequel la wollastonite comprend des fibres présentant des rapports longueur/diamètre pas inférieur à 6, dans une proportion pas inférieure à 60 pour cent en poids, et des fibres présentant un diamètre ne dépassant pas 5 µm, dans une proportion pas inférieure à 80 pour cent en poids.

6. Utilisation d'au moins une matière fibreuse choisie parmi la wollastonite, la xonotlite et les trichites représentées par la formule aAₓO_{y}·bB₂O₃ (dans laquelle a et b représentent, indépendamment l'un de l'autre, un nombre entier compris entre 1 et 9 ;A représente un métal divalent ou trivalent ; et x et y représentent, indépendamment l'un de l'autre, un nombre entier compris entre 1 et 3), dans le but de réduire le facteur de dissipation diélectrique d'une résine thermoplastique ou d'une résine thermodurcissable.
